# EUROPÄISCHE PATENTSCHRIFT

(11) **EP 3 529 866 B1**
(45) Veröffentlichungstag und Bekanntmachung des Hinweises auf die Patenterteilung: **19.05.2021**
(21) Anmeldenummer: 18702135.7
(22) Anmeldetag: 17.01.2018
(51) Int. Cl.: H01R 13/66

(54) **ELEKTRISCHER STECKVERBINDER MIT EINEM STECKZYKLENZÄHLER UND VERFAHREN ZU DESSEN BETRIEB**
ELECTRIC PLUG CONNECTOR HAVING A PLUG-IN CYCLE COUNTER, AND METHOD FOR THE OPERATION THEREOF
CONNECTEUR ÉLECTRIQUE AVEC UN COMPTEUR DE CYCLES DE CONNEXION ET PROCÉDÉ POUR SON FONCTIONNEMENT

(30) Priorität: 20.01.2017 DE 102017200931
(43) Veröffentlichungstag der Anmeldung: 28.08.2019
(73) Patentinhaber: Siemens Aktiengesellschaft, 80333 München (DE)
(72) Erfinder: SCHIEFELBEIN, Frank-Peter, 14469 Potsdam (DE); WEGENER, Christian, 12103 Berlin (DE)
(86) Internationale Anmeldenummer: PCT/EP2018/051046
(87) Internationale Veröffentlichungsnummer: WO 2018/134217

(56) Entgegenhaltungen:
- WO-A1-2015/070946
- JP-A- 2016 100 114

## Beschreibung

Die Erfindung betrifft einen elektrischen Steckverbinder mit einer elektrischen Kontaktstruktur und einem Steckzyklenzähler. Außerdem betrifft die Erfindung ein Verfahren zum Betrieb eines solchen Steckverbinders.

Ein derartiger Steckverbinder ist beispielsweise aus der DE 10 2010 045 329 A1 bekannt. Steckzyklenzähler können beispielsweise bei Steckverbindungen zum Einsatz kommen, die für die Ladung elektrischer Kraftfahrzeuge zum Einsatz kommen. Der Steckzyklenzähler soll verhindern, dass der Steckverbinder über eine vorbestimmte Steckzyklenzahl hinaus verwendet wird, um Fehlfunktionen zu vermeiden. Der Steckzyklenzähler kann beispielsweise mit der Ladestation für das elektrische Kraftfahrzeug kommunizieren und eine Aktivierung derselben verhindern, sofern die zulässige Steckzyklenzahl des Steckverbinders überschritten wird.

Gemäß der WO 2015/070946 A1 ist ein Steckverbinder beschrieben, der zum Zählen der Steckzyklen ein mechanisches Zählwerk aufweist. Der Steckverbinder weist einen Stift auf, der bei Ausbilden der Steckverbindung in den Steckverbinder hineingeschoben wird und hierbei das mechanische Zählwerk betätigt.

Aus der JP 2016-100114 A ist ein Stecker mit einem drahtlosen IC-Tag bekannt, in dem eine Stecker-ID gespeichert ist, die eine Identifikationsinformation des Steckers ist. Die Steckdose wird durch die erzeugte Leistung des piezoelektrischen Elements betrieben und liest die Stecker-ID aus dem drahtlosen IC-Tag aus.

Elektrische Steckverbinder finden in der Technik breite Anwendung. Gemäß der Erfindung soll als Steckverbinder ein Bauelement verstanden werden, das es gestattet, elektrische Leiter anzuschließen, wobei der Steckverbinder die Aufgabe übernimmt, mit einem passenden Gegenstück eine Verbindung herzustellen und/oder zu trennen (das Verbinden und Trennen stellt einen Steckzyklus dar). Das passende Gegenstück ist somit auch ein Steckverbinder. Meistens bestehen Steckverbindungen somit aus einem Stiftkontakt und einem Buchsenkontakt, in den der Stiftkontakt eingesteckt werden kann. Darüber hinaus gibt es auch Steckkontakte, bei denen die Kontakte so konstruiert sind, dass sie ineinandergreifen und so auf beiden Seiten der Steckverbindung die gleiche Anschlussgeometrie des Steckverbinders verwendet werden kann. Kontaktstifte können vorzugsweise flach, quadratisch oder rund ausgeführt sein. Der Buchsenkontakt kann beispielsweise aus einem Gabelkontakt bestehen, der vorzugsweise aus einem flachen Blech gestanzt werden kann. Der Kontaktbereich, der für den Kontaktstift vorgesehen ist, ist flexibel ausgeführt, so dass zum Herstellen des Kontakts nach Einstecken des Stiftkontakts ein Anpressdruck entsteht. Um diesen zu erhöhen, können auch sogenannten Doppel- oder Dreifachfederkontakte verwendet werden, bei denen das gestanzte Blech zur Erzeugung des Federeffekts gefaltet wird. Präzisionskontakte können auch andere Federmechanismen enthalten und sind mit mehreren Kontaktlamellen ausgestattet.

Mit Steckverbindern werden elektromechanische, lösbare Verbindungen der Kontaktpartner erzeugt. Als Kontaktpartner können Schaltungsträger, elektronische oder elektromechanische Baugruppen oder Leiterplatten zum Einsatz kommen. Es können Verbindungen zu externen Geräten, wie Sensoren, Tastaturen, Displays, Kabeln oder anderen Baugruppen, hergestellt werden. Auch lassen sich Schaltungsträger untereinander direkt verbinden.

Wesentliche Motivation des Einsatzes einer Steckverbindung ist deren Lösbarkeit. Diese kann aus unterschiedlichen Gründen erwünscht sein, z. B. aus fertigungsstrategischen Überlegungen, um Baugruppen oder Subsysteme unabhängig voneinander herstellen zu können und erst bei der Endmontage zusammenzuführen. Eine andere Anforderung kann durch die Möglichkeit eines Auswechselns von Baugruppen gegeben sein. Außerdem ist das wiederholte Verbinden von Geräten untereinander oder Geräten mit Kabeln ein typischer Anwendungsfall. Der Anwendungsfall bestimmt bei der Auslegung der Steckverbindung, für wie viele Steckzyklen diese vorgesehen werden soll. Werden beispielsweise Leiterplatten in einem Schaltschrank mit Steckverbindern verbunden, entstehen Steckzyklen nur bei einem Austausch von Schaltungsträgern, was vergleichsweise selten erforderlich wird. Die Steckverbinder können typischerweise für 25 Steckzyklen ausgelegt werden. Ist die Steckverbindung für ein Anschlusskabel (beispielsweise Ladekabel) gedacht, führt dieses zu vergleichsweise hohen erforderlichen Steckzyklen von über 100 oder sogar über 1000 Steckzyklen.

Es besteht daher der Bedarf, elektrische Steckverbinder mit Steckzyklenzählern auszustatten, was einen zusätzlichen konstruktiven Aufwand bewirkt, der mit Kosten verbunden ist. Die Aufgabe der Erfindung besteht daher darin, einen elektrischen Steckverbinder mit Steckzyklenzähler anzugeben, bei dem der Steckzyklenzähler eine hohe Funktionszuverlässigkeit aufweist und mit dem der Steckzyklenzähler kostengünstig hergestellt werden kann. Außerdem ist es Aufgabe der Erfindung, ein Verfahren zum Betrieb eines solchen Steckverbinders anzugeben, welches eine hohe Funktionszuverlässigkeit aufweist.

Die Aufgabe wird mit einem elektrischen Steckverbinder gemäß Anspruch 1 gelöst. Bei dem erfindungsgemäßen Einsatz eines piezoelektrischen Sensors macht man sich den Effekt zunutze, dass zum Ausbilden des elektrischen Kontakts im Steckverbinder immer eine gewisse Kontaktkraft gewährleistet sein muss, mit der die Kontaktflächen zur Übertragung eines elektrischen Stroms aufeinander gepresst werden müssen. Durch die mechanische Verbindung des Sensors mit der Kontaktstruktur, die zum Ausbilden des elektrischen Kontakts eine Kontaktfläche zur Verfügung stellt, ist es möglich, dass der Steckzyklus mittels des piezoelektrischen Sensors dadurch erkannt wird, dass eine Kontaktkraft in dem Steckverbinder aufgebaut wird. Diese Kontaktkraft überträgt sich dann auf den piezoelektrischen Sensor, wobei dieser ebenso wie die Kontaktstruktur elastisch verformt wird.

Damit erzeugt ein Steckvorgang sowohl beim Schließen als auch beim Öffnen der elektrischen Verbindung einen elektrischen Impuls im piezoelektrischen Sensor. Um diesen detektieren zu können, muss der piezoelektrische Sensor von dem Kontaktelement elektrisch isoliert sein. Es besteht somit lediglich eine mechanische Verbindung zur Übertragung der Kontaktkraft.

Üblicherweise ist der Steckverbinder in einem Gehäuse des Steckverbinders (Steckverbindergehäuse) untergebracht. Dieses erfüllt die Funktion einer elektrischen Isolation der Steckkontakte untereinander und gegenüber der Umgebung. Mechanische Funktionen des Gehäuses liegen in der Positionierung der Kontaktstruktur sowie der Aufnahme des anderen Steckverbinders zum Herstellen des elektrischen Kontakts. Die Halterung des anderen Steckverbinders kann durch einen Kraftschluss oder durch einen Formschluss erfolgen. Außerdem ist es von besonderem Vorteil, wenn sich der piezoelektrische Sensor in dem Gehäuse abstützt, damit die Kontaktkraft auf den piezoelektrischen Sensor einwirken kann. Hierdurch entsteht vorteilhaft eine einfach zu montierende Bauform des elektrischen Steckverbinders, bei dem der piezoelektrische Sensor in das Gehäuse eingesetzt werden kann. Es ist aber auch möglich, dass der piezoelektrische Sensor derart in die Kontaktstruktur integriert wird, dass deren Verformung auch den piezoelektrischen Sensor verformt. Dies kann gemäß einer Ausgestaltung der Erfindung dadurch erreicht werden, dass der piezoelektrische Sensor zwischen zwei Teilbereichen der Kontaktstruktur mechanisch fixiert ist, wobei diese Teilbereiche bei Steckvorgängen relativ zueinander beweglich sind.

Gemäß einer anderen Ausgestaltung der Erfindung kann vorgesehen werden, dass der piezoelektrische Sensor aus mehreren Scheiben besteht, die mechanisch in Reihe geschaltet sind, wobei die Scheiben beidseitig von Elektrodenplatten begrenzt sind, die wechselseitig elektrisch parallel geschaltet sind. Hierdurch lässt sich vorteilhaft ein piezoelektrischer Sensor erzeugen, bei dem der elektrische Stromimpuls, der bei Auftreten der Kontaktkraft entsteht, ein Vielfaches des Impulses beträgt, der bei einem Aufbau des piezoelektrischen Sensor nur aus einer Scheibe entstehen würde. Hierdurch lässt sich vorteilhaft das Sensorsignal beim Stecken oder Lösen des Steckverbinders einfacher erfassen, da eine Auswertungseinheit zur Erfassung des Steckvorgangs weniger empfindlich ausgeführt sein muss. Erfindungsgemäß ist die Auswertungseinheit in den Steckverbinder integriert und besitzt ein Speichermodul für die erfolgte Zahl der Steckzyklen.

Gemäß einer vorteilhaften Ausgestaltung der Erfindung besitzt die Auswertungseinheit auch ein Ausgabemodul für eine die Steckzyklenzahl betreffende Information. Das Ausgabemodul kann entweder die Zahl der bereits erfolgten Steckzyklen ausgeben (z. B. ein Display) oder nur das Überschreiten der Höchstzahl an Steckzyklen anzeigen (z. B. eine LED). Es ist hierdurch möglich, die relevante Information über die Steckzyklen direkt am Steckergehäuse anzuzeigen.

Alternativ kann das Speichermodul auch ausgelesen werden, um die Steckzyklenzahl zu erhalten. Als Ausgabemodul kann zu diesem Zweck ein RFID-Tag Verwendung finden (RFID steht für Radio Frequency Identification). Das RFID-Tag besteht aus einem Transponder und einer Antenne, wobei der Transponder über die Antenne mit elektrischer Energie versorgt wird. Vorteilhaft ist es, wenn während des Auslesens auch die restliche Auswertungseinheit durch das als Transponder mit Antenne ausgeführte Ausgabemodul (also das RFID-Tag) mit Energie versorgt wird.

Die Energieversorgung der Auswertungseinheit während der Registrierung der Steckzyklen kann gemäß einer anderen Ausgestaltung der Erfindung durch den piezoelektrischen Sensor ausgebildet sein. Hierbei wird die elektrische Ladung, die durch den piezoelektrischen Effekt erzeugt wird, nicht nur zur Zählung der Steckzyklen verwendet, sondern der durch die Ladung erfolgende Stromfluss wird als Energieversorgung für die Auswertungseinheit verwendet. Vorteilhaft kann die Auswertungseinheit damit als autarkes System arbeiten, ohne mit einem Energiespeicher, beispielsweise in Form einer Batterie, ausgestattet zu werden. Dies setzt weiterhin voraus, dass das Speichermodul einen nicht flüchtigen Speicher enthält, der zur Speicherung von einer Energieversorgung unabhängig ist.

Gemäß einer besonderen Ausgestaltung der Erfindung kann vorgesehen sein, dass der piezoelektrische Sensor auf einer Aufnahmefläche des Gehäuses für einen korrespondierenden Steckverbinder angebracht oder unterhalb dieser Aufnahmefläche in das Material des Gehäuses eingebettet ist. In diesem Fall wird der Steckzyklus dadurch detektiert, dass auf die Aufnahmefläche durch den korrespondierenden Steckverbinder eine Kraft ausgeübt wird. Hierbei kann es sich um eine Druckkraft handeln, die aufgrund der Haltekräfte oder der entstehenden Reibung beim Stecken auf die Aufnahmefläche wirkt, wenn der korrespondierende Steckverbinder mit dieser Aufnahmefläche in Kontakt kommt. Es ist jedoch auch möglich, dass eine zum Schließen der Steckverbindung notwendige Steckkraft im piezoelektrischen Sensor auslöst, je nachdem welche Aufnahmefläche zur Unterbringung des Sensors genutzt wird.

Der piezoelektrische Sensor kann auf der Aufnahmefläche angebracht sein, wobei dieser damit selbst einen Teil der Aufnahmefläche zur Verfügung stellt. Der piezoelektrische Sensor kommt dann mit dem korrespondierenden Steckverbinder in direktem Kontakt. Eine andere Möglichkeit besteht darin, den piezoelektrischen Sensor unterhalb der Aufnahmefläche anzuordnen, wobei dieser dann in das Material des Gehäuse eingebettet ist. In diesem Fall kommt der Piezosensor nicht mit dem korrespondierenden Steckverbinder in Kontakt, sondern erfährt eine das Sensorsignal auslösende Druckerhöhung durch eine elastische Verformung des ihn umgebenden Materials des Gehäuses.

Gemäß einer anderen Ausgestaltung der Erfindung ist vorgesehen, dass der piezoelektrische Sensor zwischen zwei Teilbereichen der Kontaktstruktur mechanisch fixiert ist, wobei diese Teilbereiche relativ zueinander beweglich sind. Beispielsweise kann die Kontaktstruktur gabelförmig ausgebildet sein, wobei der piezoelektrische Sensor in dem durch die Gabel gebildeten Zwischenraum untergebracht ist (die Gabel bildet dabei einen Stiftkontakt). Beim Schließen der Steckverbindung wird der die Gabel zusammengedrückt, wodurch ein Sensorsignal in dem piezoelektrischen Sensor erzeugt wird. Hierbei handelt es sich vorteilhaft um eine besonders platzsparende Ausführung, die vorzugsweise in als Stiftkontakt wirkenden Steckverbindern zum Einsatz kommen kann. Dabei wird die Außenseite der Gabel als Kontaktfläche für den zugehörigen Buchsenkontakt verwendet, während die Innenseite der Gabel, wie bereits erläutert, der Aufnahme des piezoelektrischen Sensors dient.

Eine wieder andere Ausgestaltung der Erfindung sieht vor, dass der piezoelektrische Sensor zwischen der Kontaktstruktur und dem Gehäuse mechanisch fixiert ist, wobei die Kontaktstruktur relativ zum Gehäuse beweglich ist. Mit anderen Worten wird die Kontaktstruktur beim Schließen des Kontakts elastisch verformt, während das Gehäuse mit einer größeren mechanischen Steifigkeit ausgeführt ist. Daher wird beim Schließen einer Steckverbindung der piezoelektrische Sensor über die Kontaktstruktur mit der Kontaktkraft beaufschlagt, wodurch ein Sensorsignal erzeugt wird. Dieser Aufbau ist vorzugsweise für Buchsenkontakte geeignet, weil sich die Buchsen beim Schließen der Steckverbindung zu dem sie umgebenden Gehäuse hin verformen.

Weiterhin wird die oben genannte Aufgabe mit dem eingangs angegebenen Verfahren erfindungsgemäß dadurch gelöst, dass mit dem Steckverbinder eine Steckverbindung geschlossen oder geöffnet wird und die beim Herstellen oder Öffnen entstehenden Kräfte (wie bereits beschrieben handelt es sich um Kontaktkräfte, Druckkräfte oder Steckkräfte) an dem piezoelektrischen Sensor eine elektrische Ladung erzeugen, die einen Stromfluss in einem Mess-Stromkreis hervorruft. Dieser Stromfluss wird gezählt. Mit dem Verfahren werden die oben bereits erläuterten Vorteile erreicht.

Ein Stromfluss wird sowohl beim Öffnen als auch beim Schließen des Steckverbinders erzeugt. Dies liegt daran, dass eine elektrische Ladung an dem piezoelektrischen Sensor immer entsteht, wenn sich die Druckbeaufschlagung des Piezokristalls ändert. Dies erfordert es, dass je zwei gemessene Stromimpulse durch die Auswertungseinheit als ein Steckzyklus interpretiert wird.

Gemäß einer Ausgestaltung des Verfahrens kann vorgesehen werden, dass die durch den piezoelektrischen Sensor erzeugte elektrische Energie zum Betreiben einer Auswertungseinheit mit einem Speichermodul für die erfolgte Zahl der Steckzyklen verwendet wird. Durch Öffnen oder Schließen der Steckverbindung und den daraus resultierenden Stromimpuls wird die Auswertungseinheit jeweils aufgeweckt, wobei die elektrische Energie ausreicht, um das detektierte Ereignis im Speichermodul abzulegen.

Weitere Einzelheiten der Erfindung werden nachfolgend anhand der Zeichnung beschrieben. Gleiche oder sich entsprechende Zeichnungselemente werden jeweils mit den gleichen Bezugszeichen versehen und sind nur insoweit mehrfach erläutert, wie sich Unterschiede zwischen den einzelnen Figuren ergeben. Es zeigen:
- Figur 1: ein Ausführungsbeispiel für zwei komplementäre Steckverbinder, die zu einer Steckverbindung zusammengesteckt werden können,
- Figur 2: den Einsatz eines aus mehreren Scheiben bestehenden piezoelektrischen Sensors, der an die Stelle II gemäß Figur 2 des Steckverbinders eingebaut werden könnte und
- Figur 3: Ausführungsbeispiele für die alternative Unterbringung von piezoelektrischen Sensoren in einem Bereich III gemäß Figur 1 im Querschnitt.

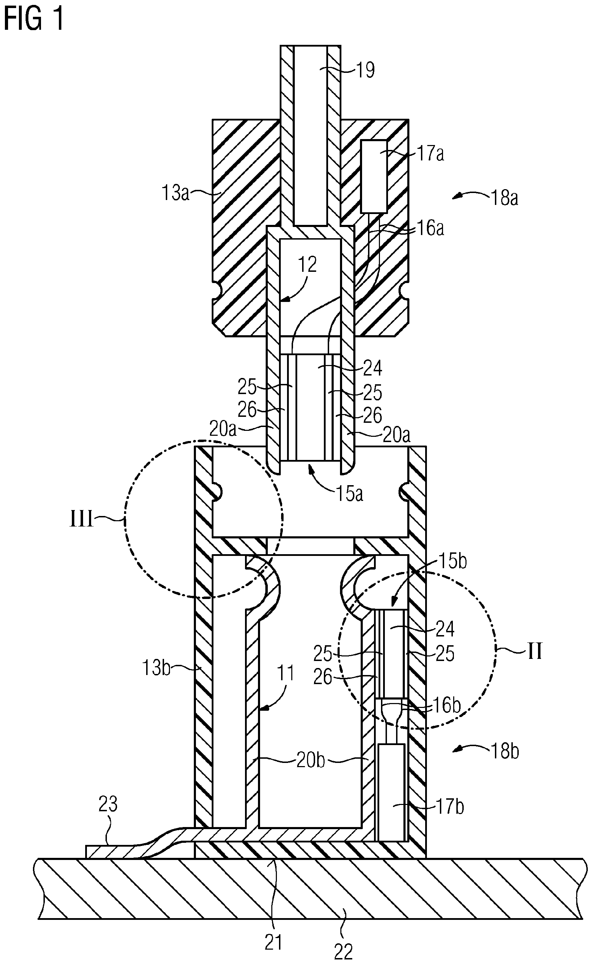

In Figur 1 sind zwei Steckverbinder 18a, 18b mit Kontaktstrukturen 11, 12 dargestellt, wobei die eine als Buchsenkontakt 11 und die andere als Stiftkontakt 12 ausgeführt ist. Diese sind komplementär ausgebildet und können daher zu einer Steckverbindung geschlossen werden. Beide Kontaktstrukturen weisen ein Gehäuse 13a, 13b auf, in welchem eine Kontaktstruktur untergebracht ist. Außerdem ist jeweils ein piezoelektrischer Sensor 15a, 15b vorgesehen, der über einen Messstromkreis 16a, 16b mit je einer Auswertungseinheit 17a, 17b in Verbindung steht.

Der Steckverbinder 18a mit dem Stiftkontakt 12 wird dadurch hergestellt, dass der Stiftkontakt 12 in das Gehäuse 13a eingegossen wird. Der Stiftkontakt 12 weist eine Aufnahmebuchse 19 für ein nicht dargestelltes Kabelende auf, wobei am entgegengesetzten Ende des Stiftkontakts 12 zwei Zungen 20a angebracht sind, die als relativ zueinander bewegliche Teilbereiche ausgeführt sind. Die Relativbewegung dieser Teilbereiche ist aufgrund der Elastizität des metallischen Materials des Stiftkontakts möglich. Zwischen den Zungen 20a ist der piezoelektrische Sensor 15a gehalten.

Der Steckverbinder 18b ist als Buchsenkontakt 11 ausgeführt und besitzt eine Montagefläche 21 zur Montage auf einem Schaltungsträger 22. Der Buchsenkontakt 11 weist ein Kontaktplättchen 23 auf, welches aus dem Gehäuse 13b herausgeführt ist und auf dem Schaltungsträger 22 aufliegt. Hierdurch ist eine elektrische Kontaktierung des Buchsenkontakts 11 auf dem Schaltungsträger 22 beispielsweise mittels einer nicht näher dargestellten Lötverbindung möglich. Außerdem weist auch der Buchsenkontakt 11 zwei Zungen 20b auf, die durch den Stiftkontakt 12 beim Schließen der Steckverbindung auseinandergebogen werden. Hierbei wird im piezoelektrischen Sensor 15b, der zwischen einer der Zungen 20b und dem Gehäuse 13b angebracht ist, ein elektrisches Signal generiert, welches über den Messstromkreis 16b in die Auswertungseinheit 17b eingespeist werden kann. Die piezoelektrischen Sensoren bestehen jeweils aus einem Piezokristall 24, an dessen Oberseite und Unterseite Elektrodenplatten 25 angebracht sind. Diese sind mit dem Stromkreis 16a, 16b verbunden. Außerdem ist zu den metallischen Kontaktstrukturen 11, 12 jeweils eine elektrische Isolationsschicht 26 angeordnet, damit eine Ladung auf dem Piezokristall nicht in die Kontaktstruktur 11, 12 abließen kann. Das Gehäuse 13b ist aus Kunststoff gefertigt, weswegen eine Isolation des piezoelektrischen Sensors 15b zum Gehäuse 13b nicht notwendig ist. Anders verhält sich dies bei dem piezoelektrischen Sensor 15a, der sich beidseitig an den Zungen 20a abstützt und deswegen beidseitig Isolationsschichten 26 aufweist.

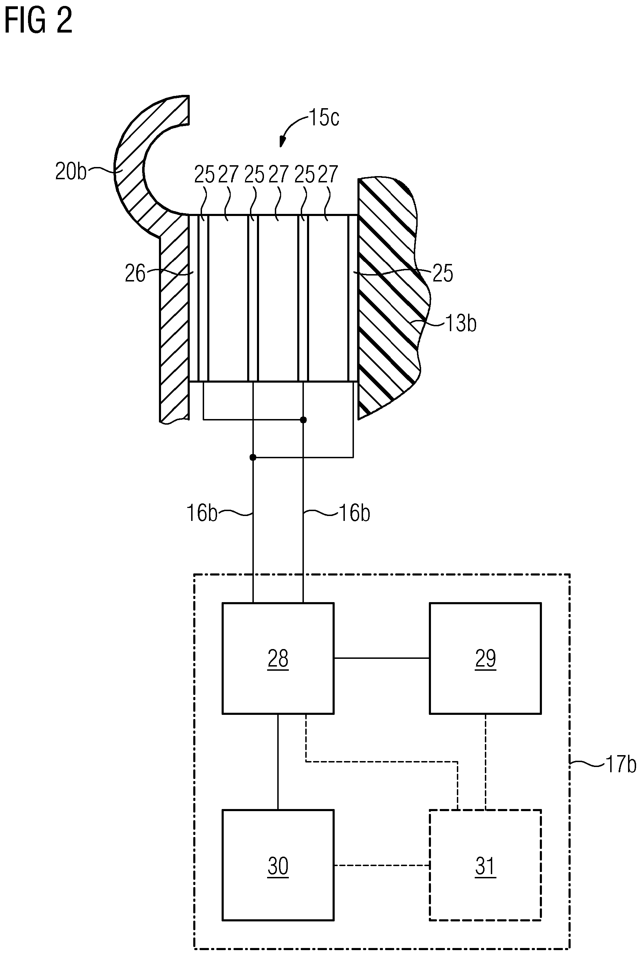

Der piezoelektrische Sensor 15c gemäß Figur 2 ist mehrschichtig aufgebaut. Er besteht aus mehreren Scheiben 27 aus einem piezoelektrischen Material, beispielsweise einer piezoelektrischen Keramik, wie einer Blei-Zirkonat-Titanat-Keramik oder einem einkristallinen Material, wie Quarz, Turmalin oder Galliumphosphat. Diese Scheiben 27 sind zwischen Elektrodenplatten angeordnet, die wechselseitig den Pluspol bzw. den Minuspol für den Stromkreis 16a, 16b bilden. Damit sind die Scheiben mechanisch in Serie elektrisch jedoch parallel geschaltet, wodurch die erzeugbare Ladungsmenge vergrößert wird, um ein besser detektierbares Signal zu erhalten und gleichzeitig die Energieversorgung der Auswertungseinheit 17b zu erhöhen.

Die Auswertungseinheit 17b ist schematisch als Blockschaltbild dargestellt. Sie weist einen Prozessor 28 auf, der die Auswertungseinheit 17b steuert. Einerseits wird die Auswertungseinheit über den Prozessor 28 aktiviert, sobald ein Sensorsignal des piezoelektrischen Sensors 15c über den Stromkreis 16b fließt, wodurch die Auswertungseinheit 17b aktiviert wird. Dieses Ereignis wird in dem Prozessor gezählt und in einem Speichermodul 29 als Zahl abgelegt.

Weiterhin ist ein Ausgabemodul 30 vorgesehen, welches durch unterschiedliche Funktionen gekennzeichnet sein kann. Beispielsweise kann das Ausgabemodul 30 aus einer roten und einer grünen Leuchtdiode bestehen, wobei noch während des Lösens oder Schließens der Steckverbindung der erzeugte Strom genutzt wird, um im Rahmen der Lebensdauer ein grünes Blinksignal auszugeben und bei Überschreiten der Lebensdauer ein rotes Blinksignal auszugeben. Stattdessen kann auch ein LCD-Display verwendet werden, welches die Zahl der Steckzyklen anzeigt. Hierbei ist zu beachten, dass ein Steckzyklus aus zwei Ereignissen, nämlich dem Öffnen und Schließen, besteht, so dass die gezählten Ereignisse durch zwei geteilt werden müssen, um die Zahl der Steckzyklen zu ermitteln.

Eine weitere Möglichkeit, die optional oder zusätzlich zu den bereits erwähnten Anwendungen finden kann, ist die Ausgestaltung des Ausgabemoduls als RFID-Tag. Hierdurch besteht die Möglichkeit, die Zahl der Steckzyklen mit einem Lesegerät jederzeit auslesen zu können, wobei die Ernergieversorgung von außen durch eine Antenne erfolgt. Die Funktionalität des Transponders kann mit dem Prozessor 28 eine Baueinheit bilden oder in dem Ausgabemodul 30 integriert sein. Auf jeden Fall muss die über die Antenne in die Auswertungseinheit 17b eingespeiste Energie auch ausreichen, damit der Prozessor 28 aus dem Speichermodul 29 die Information der Zyklenzahl abruft.

Optional und daher gestrichelt dargestellt kann zusätzlich auch ein Energiemodul 31 in der Auswertungseinheit 17b integriert sein. Hierbei kann es sich um einen elektrischen Energiespeicher oder auch um eine Kombination aus Energiespeicher und Energieerzeuger handeln. Im letzteren Falle muss der Energiespeicher aufladbar sein, um die Energie des Energieerzeugers zwischenspeichern zu können. Der Energieerzeuger kann beispielsweise eine Solarzelle sein.

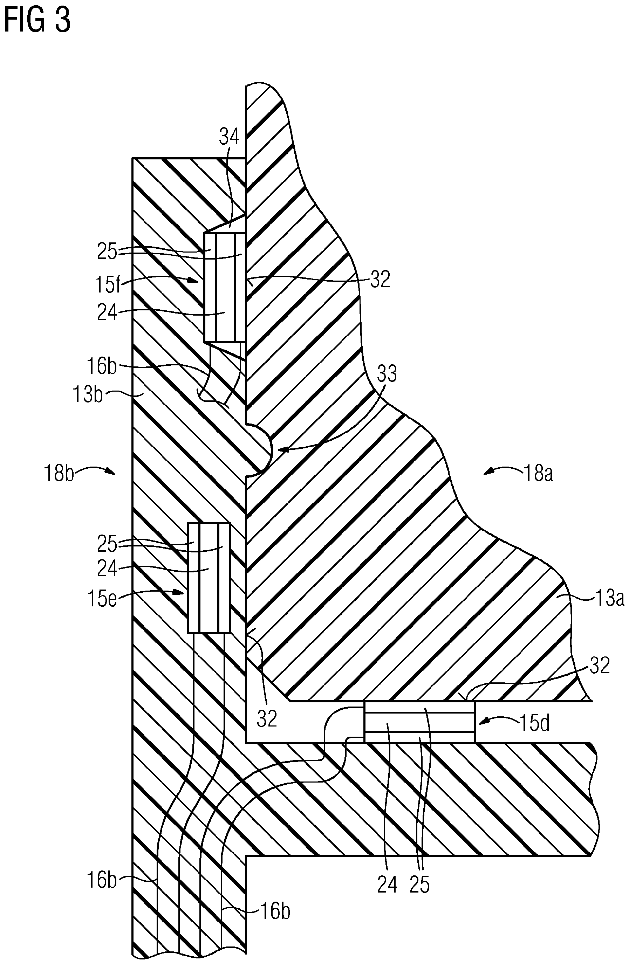

In Figur 3 sind weitere Anbringungsmöglichkeiten für piezoelektrische Sensoren 15d, 15e, 15f in dem Gehäuse 18b gezeigt, mit denen unterschiedliche Effekte des Steckvorgangs detektiert werden können. Der piezoelektrische Sensor 15d ist an der Wand des Gehäuses 13b angebracht und bildet so den Teil einer Aufnahmefläche 32. Bei der Aufnahmefläche handelt es sich um den Teil der Fläche in dem Steckverbinder 18b, die mit dem Steckverbinder 18a im geschlossenen Zustand direkt kontaktiert. Beim Schließen der Steckverbindung 18a, 18b wird eine Steckkraft aufgebracht, die auch zum Einschnappen einer Rastverbindung 33 beiträgt. Die Steckkraft wird über die Aufnahmefläche 32 auf den piezoelektrischen Sensor 15d übertragen und kann so gezählt werden.

Ein weiterer Teil der Aufnahmefläche 32 ist zwischen den Seitenwänden der beiden Gehäuse 13a, 13b ausgebildet. Durch die Passung zwischen den Bauteilen wird auf das Gehäuse 13b ein Druck ausgeübt, welcher durch den piezoelektrischen Sensor 15e detektiert werden kann. Dieser ist vollständig in das Material des Gehäuses 13b eingegossen, wobei dieses elastisch ist und der durch das Gehäuse 13a ausgeübte Druck auf den eingegossenen piezoelektrischen Sensor 15e übertragen wird.

Der piezoelektrische Sensor 15f ist in einer Vertiefung des Gehäuses 13b derart angebracht, dass dieser einen Teil der Aufnahmefläche 32 bildet und beim Stecken daher mit dem Gehäuse 13a in Kontakt kommt. Während des Steckvorgangs entsteht daher eine Reibkraft, die sich auf dem piezoelektrischen Sensor überträgt und ein elektrisches Signal des piezoelektrischen Sensors auslöst. Anders als die bereits beschriebenen piezoelektrischen Sensoren 15a, 15b, 15c, 15d, 15e, die den Longitudinaleffekt zur Erzeugung des Sensorsignals nutzen, wird bei dem Sensor 15f zur Erzeugung des Sensorsignals der Schäleffekt genutzt. Auch zur Ausnutzung des Schäleffekts kann der Sensor, wie in Figur 2 beschrieben, mehrschichtig aufgebaut sein.

In den Figuren 1 bis 3 sind für die Sensoren 15a bis 15f Einbaubeispiele angegeben. Um Steckzyklen erfassen zu können, sind nicht notwendigerweise mehrere Sensoren erforderlich, auch wenn diese die Sicherheit der Erfassung von Steckzyklen erhöhen. Um für einen Steckverbinder Steckzyklen zählen zu können, benötigt man in diesem mindestens einen piezoelektrischen Sensor. Sofern die Steckverbindung miteinander fest zugeordneten Steckverbindern durchgeführt werden soll, genügt es sogar, nur in einem der beiden Steckverbinder die Steckzyklen zu zählen.

## Patentansprüche

1. Elektrischer Steckverbinder mit einem Gehäuse (13a, 13b) in dem zumindest teilweise eine elektrische Kontaktstruktur (11, 12), ein Steckzyklenzähler und eine Auswertungseinheit (17a, 17b) mit einem Speichermodul (29) angeordnet sind, wobei der Steckzyklenzähler zum Detektieren von Steckvorgängen mit einem piezoelektrischen Sensor (15a, 15b) ausgestattet ist, wobei der piezoelektrische Sensor (15a, 15b) mit der Kontaktstruktur (11, 12) und/oder mit dem Gehäuse mechanisch verbunden ist,
und wobei die Auswertungseinheit (17a, 17b) zum Speichern der detektierten Zahl von Steckvorgängen in dem Speichermodul (29) ausgebildet ist.

2. Steckverbinder nach Anspruch 1,
**dadurch gekennzeichnet,**
**dass** die elektrische Kontaktstruktur als Stiftkontakt (12) oder als Buchsenkontakt (11) ausgeführt ist.

3. Steckverbinder nach einem der voranstehenden Ansprüche,
**dadurch gekennzeichnet,**
**dass** der piezoelektrische Sensor (15d, 15e, 15f) an einer Aufnahmefläche (32) des Gehäuses (13a, 13b) für einen korrespondierenden Steckverbinder angebracht oder unterhalb dieser Aufnahmefläche in das Material des Gehäuses eingebettet ist.

4. Steckverbinder nach einem der Ansprüche 1 oder 2,
**dadurch gekennzeichnet,**
**dass** der piezoelektrische Sensor (15a) zwischen zwei Teilbereichen der Kontaktstruktur (12) mechanisch fixiert ist, wobei diese Teilbereiche relativ zueinander beweglich sind.

5. Steckverbinder nach einem der voranstehenden Ansprüche,
**dadurch gekennzeichnet,**
**dass** der piezoelektrische Sensor (15b) zwischen der Kontaktstruktur (11) und dem Gehäuse (13a, 13b) mechanisch fixiert ist, wobei die Kontaktstruktur (11) relativ zum Gehäuse beweglich ist.

6. Steckverbinder nach einem der voranstehenden Ansprüche,
**dadurch gekennzeichnet,**
**dass** der piezoelektrische Sensor aus mehreren Scheiben (27) besteht, die mechanisch in Reihe geschaltet sind, wobei die Scheiben (27) beidseitig von Elektrodenplatten (25) begrenzt sind, die wechselseitig elektrisch parallelgeschaltet sind.

7. Steckverbinder nach Anspruch 1,
**dadurch gekennzeichnet,**
**dass** die Auswertungseinheit (17a, 17b) ein Ausgabemodul (30) für eine die Steckzyklenzahl betreffende Information aufweist.

8. Steckverbinder nach einem der Ansprüche 1 oder 7,
**dadurch gekennzeichnet,**
**dass** die Energieversorgung der Auswertungseinheit (17a, 17b) durch den piezoelektrischen Sensor (15a, 15b) ausgebildet ist.

9. Steckverbinder nach Anspruch 8,
**dadurch gekennzeichnet,**
**dass** die Energieversorgung der Auswertungseinheit (17a, 17b) zusätzlich durch das als Transponder mit Antenne ausgeführte Ausgabemodul (30) ausgebildet ist.

10. Verfahren zum Betrieb eines Steckverbinders nach einem der voranstehenden Ansprüche,
**dadurch gekennzeichnet,**
**dass**
• mit dem Steckverbinder eine Steckverbindung geschlossen oder geöffnet wird,
• die beim Herstellen oder Öffnen entstehenden Kräfte an dem piezoelektrischen Sensor (15a, 15b) eine elektrische Ladung erzeugen, die einen Stromfluss in einem Messstromkreis (16a, 16b) hervorruft,
• der Stromfluss gezählt wird.

11. Verfahren nach Anspruch 10,
**dadurch gekennzeichnet,**
**dass** die durch den piezoelektrischen Sensor (15a, 15b) erzeugte elektrische Energie zum Betreiben einer Auswertungseinheit (17a, 17b) mit einem Speichermodul (29) zum Zählen der Steckzyklen verwendet wird.

## Claims

1. Electric plug-in connector having an enclosure (13a, 13b) in which an electric contact structure (11, 12), a plugging cycle counter and an evaluation unit (17a, 17b) having a memory module (29) are at least partially arranged, wherein, for the purpose of detecting plugging operations, the plugging cycle counter is equipped with a piezoelectric sensor (15a, 15b), wherein the piezoelectric sensor (15a, 15b) is mechanically connected to the contact structure (11, 12) and/or to the enclosure, and wherein the evaluation unit (17a, 17b) is designed for storing the detected number of plugging operations in the memory module (29).

2. Plug-in connector according to Claim 1, **characterized in that** the electric contact structure is embodied as a pin contact (12) or as a socket contact (11).

3. Plug-in connector according to either one of the preceding claims, **characterized in that** the piezoelectric sensor (15d, 15e, 15f) is mounted on a receiving surface (32) of the enclosure (13a, 13b) for a corresponding plug-in connector, or is embedded, beneath this receiving surface, in the material of the enclosure.

4. Plug-in connector according to either one of Claims 1 and 2, **characterized in that** the piezoelectric sensor (15a) is mechanically fixed between two sub-regions of the contact structure (12), wherein these sub-regions are movable relative to each other.

5. Plug-in connector according to any one of the preceding claims, **characterized in that** the piezoelectric sensor (15b) is mechanically fixed between the contact structure (11) and the enclosure (13a, 13b), wherein the contact structure (11) is movable relative to the enclosure.

6. Plug-in connector according to any one of the preceding claims, **characterized in that** the piezoelectric sensor consists of a plurality of discs (27), which are mechanically connected in series, wherein the discs (27) are delimited on both sides by electrode plates (25), which are alternately electrically connected in parallel.

7. Plug-in connector according to Claim 1, **characterized in that** the evaluation unit (17a, 17b) has an output module (30) for information relating to the number of plugging cycles.

8. Plug-in connector according to any one of Claims 1 or 7, **characterized in that** the energy supply of the evaluation unit (17a, 17b) is realized by the piezoelectric sensor (15a, 15b).

9. Plug-in connector according to Claim 8, **characterized in that** the energy supply of the evaluation unit (17a, 17b) is additionally realized by the output module (30) embodied as a transponder having an antenna.

10. Method for operating a plug-in connector according to any one of the preceding claims, **characterized in that**
• a plug-in connection is opened or closed by means of the plug-in connector,
• the forces produced during the operation of establishing or opening generate, at the piezoelectric sensor (15a, 15b), an electric charge that causes a current flow in a measuring electric circuit (16a, 16b),
• the current flow is counted.

11. Method according to Claim 10, **characterized in that** the electrical energy generated by the piezoelectric sensor (15a, 15b) is used to operate an evaluation unit (17a, 17b) having a memory module (29) for counting the plugging cycles.

## Revendications

1. Connecteur électrique à enfichage comprenant un boîtier (13a, 13b), dans lequel sont disposés au moins en partie une structure (11, 12) de contact électrique, un compteur de cycles d'enfichage et une unité (17a, 17b) d'exploitation ayant un module (29) de mémoire, dans lequel le compte de cycles d'enfichage est, pour détecter des opérations d'enfichage, équipé d'un capteur (15a, 15b) piézoélectrique, le capteur (15a, 15b) piézoélectrique étant relié mécaniquement à la structure (11, 12) de contact et/ou au boîtier,
et dans lequel l'unité (17a, 17b) d'exploitation est constituée pour mettre le nombre détecté d'opérations d'enfichage en mémoire dans le module (29) de mémoire.

2. Connecteur à enfichage suivant la revendication 1,
**caractérisé**
**en ce que** la structure de contact électrique est réalisée sous la forme d'un contact (12) à broche ou d'un contact (11) à douille.

3. Connecteur à enfichage suivant l'une des revendications précédentes, **caractérisé en ce que** le capteur (15d, 15e, 15f) piézoélectrique est monté sur une surface (32) de réception du boîtier (13a, 13b) d'un connecteur à enfichage correspondant et/ou noyé dans le matériau du boîtier en dessous de cette surface de réception.

4. Connecteur à enfichage suivant l'une des revendications 1 ou 2, **caractérisé en ce que** le capteur (15a) piézoélectrique est immobilisé mécaniquement entre deux régions partielles de la structure (12) de contact, ces régions partielles étant mobiles l'une par rapport à l'autre.

5. Connecteur à enfichage suivant l'une des revendications précédentes, **caractérisé en ce que** le capteur (15b) piézoélectrique est immobilisé mécaniquement entre la structure (11) de contact et le boîtier (13a, 13b), la structure (11) de contact étant mobile par rapport au boîtier.

6. Connecteur à enfichage suivant l'une des revendications précédentes **caractérisé en ce que** le capteur piézoélectrique est constitué de plusieurs disques (27) qui sont montés mécaniquement en série, les disques (27) étant délimités des deux côtés par des plaques (25) d'électrode, qui sont montées électriquement en parallèle mutuellement.

7. Connecteur à enfichage suivant la revendication 1,
**caractérisé en ce que**
l'unité (17a, 17b) d'exploitation a un module (30) d'émission d'une information concernant le nombre de cycles d'enfichage.

8. Connecteur à enfichage suivant l'une des revendications 1 à 7, **caractérisé en ce que**
l'alimentation en énergie de l'unité (17a, 17b) d'exploitation est constituée par le capteur (15a, 15b) piézoélectrique.

9. Connecteur à enfichage suivant la revendication 8,
**caractérisé en ce que**
l'alimentation en énergie de l'unité (17a, 17b) d'exploitation est constituée supplémentairement par le module (30) d'émission réalisé en transpondeur avec antenne.

10. Procédé pour faire fonctionner un connecteur à enfichage suivant l'une des revendications précédentes,
**caractérisé en ce que**
• on ferme ou on ouvre une liaison d'enfichage par le connecteur à enfichage,
• les forces créées à l'établissement ou à l'ouverture produisent sur le capteur (15a, 15b) piézoélectrique une charge électrique, qui provoque un flux de courant dans un circuit (16a, 16b) de mesure,
• on décompte le flux de courant.

11. Procédé suivant la revendication 10,
**caractérisé**
**en ce que** l'on utilise l'énergie électrique, produite par le capteur (15a, 15b) piézoélectrique, pour faire fonctionner une unité (17a, 17b) d'exploitation ayant un module (29) de mémoire, afin de décompter les cycles d'enfichage.
